(19) Europäisches Patentamt
European Patent Office
Office européen des brevets

(11) **EP 4 078 206 B1**

(12) **EUROPEAN PATENT SPECIFICATION**

(45) Date of publication and mention
of the grant of the patent:
**21.02.2024 Bulletin 2024/08**

(21) Application number: **19835391.4**

(22) Date of filing: **19.12.2019**

(51) International Patent Classification (IPC):
*G01R 31/367* (2019.01)    *G01R 31/388* (2019.01)

(52) Cooperative Patent Classification (CPC):
**G01R 31/388; G01R 31/367;** G01R 31/3835

(86) International application number:
**PCT/EP2019/086430**

(87) International publication number:
**WO 2021/121609 (24.06.2021 Gazette 2021/25)**

(54) **A METHOD FOR ESTIMATING CAPACITY OF A BATTERY UNIT**

VERFAHREN ZUR KAPAZITÄTSSCHÄTZUNG EINER BATTERIEEINHEIT

PROCÉDÉ D'ESTIMATION DE LA CAPACITÉ D'UNE PILE DE BATTERIE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**26.10.2022 Bulletin 2022/43**

(73) Proprietor: **VOLVO TRUCK CORPORATION**
**405 08 Göteborg (SE)**

(72) Inventors:
• **KLINTBERG, Anton**
**423 63 Torslanda (SE)**
• **ALTAF, Faisal**
**421 43 Västra Frölunda (SE)**
• **FRIDHOLM, Björn**
**414 62 Göteborg (SE)**

(74) Representative: **Valea AB**
**Box 1098**
**405 23 Göteborg (SE)**

(56) References cited:
**US-A- 6 163 133          US-A1- 2008 255 783**
**US-A1- 2009 322 283     US-A1- 2014 350 877**
**US-A1- 2017 363 690**

**Description**

TECHNICAL FIELD

The invention relates to a method for estimating a capacity of a battery unit in an energy storage system of a vehicle. The invention further relates to a computer program, a computer readable medium, a control unit, a battery management system, and a vehicle.

The invention can be applied in any type of hybrid vehicles or electrical vehicles, such as partly or fully electrical vehicles. Although the invention will be described with respect to an electrical bus, the invention is not restricted to this particular vehicle, but may also be used in other hybrid or electrical vehicles such as electrical trucks, electrical construction equipment, and electrical cars. The invention may also be applied in any other type of electrical vehicle such as electrically powered construction equipment, electrical working machines, e.g. wheel loaders, articulated haulers, dump trucks, excavators and backhoe loaders etc.

BACKGROUND

Batteries are becoming a more common source of power for providing propulsion for vehicles. Such batteries are often rechargeable batteries and typically include a number of battery cells that may be connected in series or in parallel forming a complete battery pack for the vehicle. Typically, a battery pack includes a number of battery cells. The quality of the battery pack is partly dependent on the quality of each battery cell, thereby setting strict requirements on the production quality of the battery cells. However, the battery cells may nevertheless have somewhat different capacities despite the high quality and may also age differently due to e.g. different operating temperature of each battery cell.

In order to determine the state-of-charge (SOC) and provide capacity estimation of a series-cell configured battery pack, data on average value of battery cell voltages and battery pack current may be used. These estimations typically assume that electrochemical characteristics of all battery cells are approximately identical. However, the SOC levels for the battery cells will eventually drift apart leading to an uneven state-of-charge distribution which limits the operational performance for the battery pack. In addition, when there are discrimination among battery cells because of aging and battery cells' different electrochemical characteristics, the variation of average battery cell voltages may not represent each cell's capacity in an accurate manner. Moreover, total capacity of the battery pack assembly is normally limited by the single battery cell having the lowest capacity.

Moreover, the SOC, SOP (state-of-power), and SOE (state-of-energy) levels of the battery are typically estimated using a model of one or several battery cells of the battery pack. A common type of a battery model comprises an equivalent circuit model through which current-voltage characteristics may be obtained for the battery model. Algorithms are used together with the model and typically need inputs relating to the battery, for example the capacity and impedance of the battery cells of the battery. However, such inputs typically change as the battery ages, which makes the estimations more complicated. Furthermore, it is important that the inputs to the algorithms are accurate in order to avoid imprecise estimations of e.g. state of charge.

Further, in hybrid or electrical vehicles, it is often needed to have a sufficiently good knowledge of the battery properties for various operating conditions. Thus, there is an increasing demand for providing an on-board capacity estimation in such vehicles.

By way of example, the capacity of a battery unit can be estimated by a voltage-based estimation method using open circuit voltage and SOC correlation during an idle or operational time of the vehicle. Some examples of possible methods for capacity estimation for battery cells are described in Farmann, A., et al. "Critical review of on-board capacity estimation techniques for lithium-ion batteries in electric and hybrid electric vehicles." Journal of Power Sources 281 (2015): 114-130. However, at least some of the available methods for estimating the capacity of a battery unit require long computation time due to sophisticated algorithms. Furthermore, some of the available methods require a large amount of information storage and thereby require a lot of memory on-board the vehicle. In addition, some methods may give good estimates under certain battery operating scenarios, but not under other, and are therefore not suitable for use under various battery operating scenarios.

A commonly used method for estimating capacity is based on Coulomb counting, in which values of SOC before and after a charge or discharge episode are needed. To get a reliable estimate, the SOC values must be determined independently of the capacity, such as using a relation between the open circuit voltage (OCV) and the SOC when the battery unit is in a relaxed state, i.e. in full equilibrium without being connected to any load. However, achieving equilibrium may take several hours depending on application, and this method for estimating capacity is therefore rather time consuming.

Further relevant prior art is disclosed in US 6 163 133 A, US 2014/350877 A1, US 2008/255783 A1, US 2009/322283 A1 and US 2017/363690 A1.

Thus, it would be desirable to provide a method for efficient estimation of the capacity of a battery unit. In particular, it would be desirable to provide a method for time-efficient determination of the capacity of the battery unit during operation of the vehicle under various conditions.

DEFINITIONS

The wording "battery unit" should in the following and throughout the entire description be interpreted to include battery packs, which in themselves may comprise one or more batteries. Still further, the wording "battery unit" should be understood to also include a unit which may comprise a plurality of battery packs. However, the wording "battery unit" may also include a single battery cell. Accordingly, the wording "battery unit" may be a single battery cell, a single battery which may comprise a plurality of battery cells, a battery pack which comprises more than a single battery, as well as a module which comprises more than a single battery pack.

The term "state of charge (SOC)", as used herein, refers to the available capacity at the present status of the battery unit. The SOC may also include or represent the charge level of a battery cell, a single battery unit, a single battery pack, the electrical energy storage system or a combination thereof. The SOC is typically determined in percentage (%) between available capacity and maximum rated capacity of a new battery unit or current maximum usable capacity of a battery unit.

By the capacity of a battery unit is to be understood a charge capacity and/or a discharge capacity of the battery unit. The term "capacity" refers to a measure, typically in ampere-hours (Ah) of the charge stored by the battery unit. The battery capacity represents the maximum amount of electric charge or energy that can be extracted from the battery unit under certain given conditions.

A no-load condition of a battery unit is to be understood as a condition under which no energy is supplied to or extracted from the battery unit, that is, the battery unit is not charged or discharged by any external load. In other words, no external load is connected to the battery unit in the no-load connection.

SUMMARY

A primary object of the invention is to provide an in at least some aspect improved method for estimating a capacity of a battery unit comprised in an energy storage system of an electrically operated vehicle. In particular, it is an object to provide a more time-efficient method for estimating the capacity during various conditions of the vehicle. Another object is to provide a computationally efficient method for estimating capacity with low memory requirements.

At least the primary object is at least partly achieved by a method according to claim 1.

According to a first aspect of the invention, a method for estimating a capacity of a battery unit in an energy storage system of a vehicle is provided. The method comprises:

- during at least a first no-load condition of the battery unit, measuring a terminal voltage of the battery unit at a number of points in time to determine a transient voltage response of the battery unit,
- from the transient voltage response of the battery unit during at least the first no-load condition, estimating at least a first value of an open circuit voltage of the battery unit by means of a battery model,
- estimating the capacity of the battery unit based on at least the estimated at least first value of the open circuit voltage.

By estimating the capacity based at least partly on open circuit voltage determined from the transient voltage response of the battery unit after disconnecting a load, it is possible to estimate the capacity without having to wait for the battery unit to achieve a full equilibrium, or a full steady-state, after removal of a load. The capacity may thereby be estimated much faster after disconnection of a load, such as 5-10 times faster than by waiting for full equilibrium to be achieved. This makes it possible to determine the capacity on-board the vehicle in a more time efficient manner in comparison with prior art methods relying on open circuit voltage values measured during a relaxed steady-state of the battery unit.

Optionally, the method may further comprise:

- measuring a battery current of the battery unit during a charge process or a discharge process of the battery unit, wherein said charge process or discharge process precedes or succeeds said first no-load condition,

wherein the estimation of the capacity of the battery unit is further based on the measured battery current during said charge process or said discharge process. The charge process or discharge process may herein be the charge process or the discharge process immediately succeeding or immediately preceding said first no-load condition. If the charge process or discharge process is the charge process or the discharge process immediately preceding said first no-load condition, the first value of the open circuit voltage, used in the estimation of the capacity, is estimated from the transient voltage response following immediately upon disconnecting the load. If the charge process or the discharge process is the charge process or the discharge process immediately succeeding said first no-load condition, the first value of the open circuit voltage, used in the estimation of the capacity, is estimated from the transient voltage response following an immediately preceding charge process or discharge process. The measured current may e.g. be used for estimating the capacity using Coulomb counting, wherein one of the open circuit voltage values needed for the Coulomb counting estimation is determined from said transient voltage response in the first no-load condition.

Optionally, the method may further comprise:

- during a second no-load condition of the battery unit, determining a second value of the open circuit voltage of the battery unit, wherein said charge process or discharge process occurs between the first no-load condition and the second no-load condition,

wherein the estimation of the capacity of the battery unit is further based on the determined second value of the open circuit voltage of the battery unit. The second value of the open circuit voltage may be a value estimated from a transient voltage response using the described method, but it may also be a value determined during a relaxed no-load condition of the battery unit, i.e. when the battery unit is in full equilibrium. In this case, the second no-load condition is a relaxed no-load condition. Coulomb counting may be used to estimate the capacity based on the two open circuit voltage values and measured current during the charge or discharge process.

Optionally, the terminal voltage used to determine the transient voltage response is measured within a predetermined period of time after a termination of an immediately preceding charge process or discharge process of the battery unit. For example, the measurement may be initiated within a predetermined period of time after disconnecting the load.

Optionally, the estimation of the capacity of the battery unit based on at least the estimated at least first value of the open circuit voltage comprises using Coulomb counting. For Coulomb counting, at least two values of the state of charge (SOC) of the battery unit are needed, which two values may be determined from the open circuit voltage values prior to and subsequent to a charge or discharge process using look-up tables. Both of these open circuit voltage values, i.e. prior to and subsequent to the charge or discharge process, may be obtained as described above, but it is also possible to obtain one of the values during a relaxed no-load condition, when the battery unit is in full equilibrium. It is also possible to determine one of the SOC values from the first value of the open circuit voltage as described above, and to obtain the other SOC value in some other way.

Optionally, the method may further comprise:

- determining a level of uncertainty of the estimated at least first value of the open circuit voltage.

Optionally, the method may further comprise:

- based on said determined level of uncertainty of the estimated at least first value of the open circuit voltage, determining if the estimated at least first value of the open circuit voltage may be used for said estimation of the capacity of the battery unit.

Thus, the estimation of capacity may be prevented when the level of uncertainty in the estimated open circuit voltage is deemed to be unacceptably high. In this way, it is ensured that the capacity is only estimated when a reliable result may be expected.

Optionally, the method may further comprise:

- based on said determined level of uncertainty of the estimated at least first value of the open circuit voltage, determining a level of uncertainty of the estimated capacity of the battery unit.

Knowing the level of uncertainty is advantageous since it allows adaptation of the battery utilisation according to the level of uncertainty. For example, it there is a relatively large uncertainty, certain use of the battery unit may be prohibited. Purely by way of example, if the capacity estimate is uncertain, operating at very low state of charge may be prohibited in order to avoid damaging the battery unit.

According to the invention, the method further comprises:

- comparing the estimated at least first value of the open circuit voltage to at least one predetermined convergence criterion,

wherein the estimation of the capacity of the battery unit based on the estimated at least first value of the open circuit voltage is only carried out given that the at least one predetermined convergence criterion is fulfilled. The convergence criterion or criteria ensures that a reliable first value of the open circuit voltage has been determined. This saves computational power since the capacity needs only be estimated once the convergence criterion is fulfilled. Furthermore, in this embodiment, the at least first value of the open circuit voltage may be estimated as soon as the convergence criterion/criteria is/are fulfilled, thus making it possible to avoid an unnecessarily long waiting period before initiating the estimation. This applies particularly after charging of the battery unit.

Optionally, the battery model used in the estimation of the at least first value of the open circuit voltage is an equivalent circuit model. Such an equivalent circuit model is also known as a Thevenin battery model and includes at least one resistor-capacitor (RC) branch. In alternative embodiments, the battery model may be a black box model or an electrochemical model.

Optionally, the equivalent circuit model is a second order equivalent circuit model comprising at least two resistor-capacitor branches. This may give a more accurate estimate of the open circuit voltage than using e.g. a first order equivalent circuit model including a single RC-branch.

Optionally, a recursive estimation method or a batch estimation method is used in the estimation of the at least first value of the open circuit voltage. In particular, a recursive estimation method is advantageous for reducing the information storage needs on-board the vehicle, since such a method is less memory demanding than batch estimation methods.

Optionally, a recursive least squares estimation method is used in the estimation of the at least first value of the open circuit voltage. This is a memory efficient method giving accurate results. Additionally, when applicable, it enables continuous evaluation of the convergence criterion or convergence criteria.

According to a second aspect of the present invention, there is provided a computer program as defined in claim 11.

Effects and features of the second aspect of the invention are largely analogous to those described above in connection with the first aspect.

According to a third aspect of the present invention, there is provided a computer-readable medium as defined in claim 12.

Effects and features of the third aspect of the invention are largely analogous to those described above in connection with the first aspect.

According to a fourth aspect of the present invention, there is provided a control unit configured to perform the method according to any one of the embodiments of the first aspect. Effects and features of the fourth aspect of the invention are largely analogous to those described above in connection with the first aspect.

According to a fifth aspect of the present invention, there is provided a battery management system for an energy storage system comprising the control unit according to the fourth aspect. Effects and features of the fifth aspect of the invention are largely analogous to those described above in connection with the first aspect.

According to a sixth aspect of the present invention, there is provided a vehicle, such as a hybrid vehicle or a fully electrified vehicle, comprising an energy storage system and a control unit according to the fourth aspect. Effects and features of the sixth aspect of the invention are largely analogous to those described above in connection with the first aspect.

The vehicle may be an electrical, hybrid, or plug-in hybrid vehicle comprising an electrical motor, wherein the energy storage system provides power to the electrical motor for providing propulsion for the vehicle. It is to be noted that the vehicle can therefore be either a partly or fully electrical vehicle.

Further features of, and advantages with, the present invention will become apparent when studying the appended claims and the following description. The skilled person realizes that different features of the present invention may be combined to create embodiments other than those described in the following, without departing from the scope of the present invention.

BRIEF DESCRIPTION OF THE DRAWINGS

With reference to the appended drawings, below follows a more detailed description of embodiments of the invention cited as examples.

In the drawings:

Fig. 1    shows a vehicle in which a method according to the invention may be implemented,
Fig. 2    schematically illustrates parts of a battery model describing a battery unit;
Fig. 3    is a diagram showing current and voltage as functions of time after disconnection of a load from a battery unit,
Fig. 4    is a flow-chart illustrating a method according to an embodiment of the invention,
Fig. 5    is a flow-chart illustrating a method according to another embodiment of the invention, and
Fig. 6    is a flow-chart illustrating steps of a method according to yet another embodiment of the invention.

The drawings are schematic and not necessarily drawn to scale.

DETAILED DESCRIPTION OF EXAMPLE EMBODIMENTS OF THE INVENTION

In the present detailed description, various embodiments of the method according to the present invention are mainly described with reference to an all-electric bus, comprising a propulsion system in the form of battery powered electric motors. However, it should be noted that various embodiments of the described invention are equally applicable for a wide range of hybrid and electric vehicles.

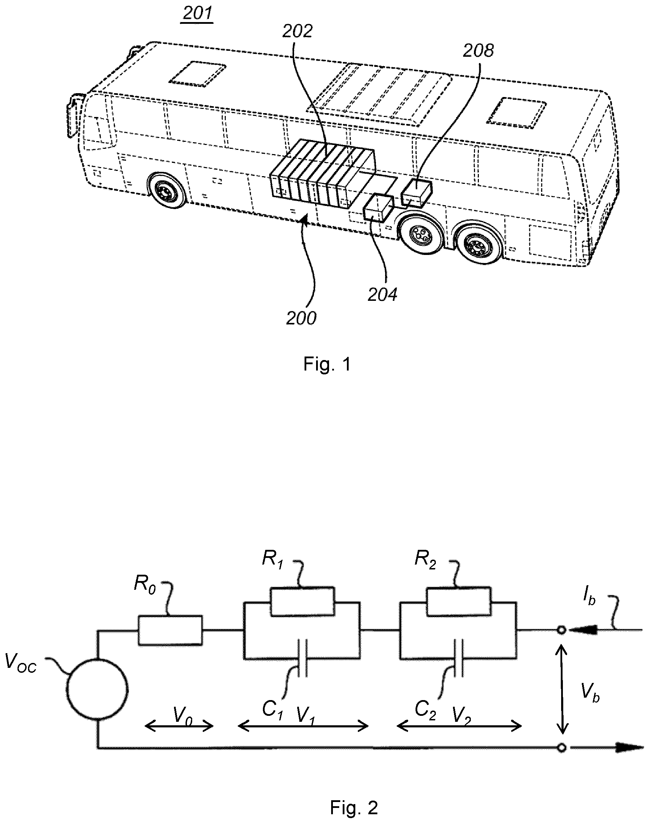

Fig. 1 shows a simplified perspective view of an all-electric vehicle in the form of a bus 201, which according to an embodiment is equipped with at least one electric machine (not shown) for operating the bus.

The bus 201 carries an electric energy storage system (ESS) 200 comprising a battery unit 202 in the form of a battery pack, the battery pack comprising a plurality of battery cells. The battery cells are connected in series to provide an output direct current (DC) voltage having a desired voltage level. Suitably, the battery cells are of lithium-ion type, but other types may also be used. The number of battery cells per battery pack may be in the range of 50 to 500 cells. It is to be noted that the ESS 200 may include a plurality of battery packs. The at least one electric machine forms a load, which when connected to the ESS 200 uses electric current provided from the battery pack 202. An on-board charger (not shown) also forms a load, which may be connected to an external power source and charge the battery pack with electric energy.

A sensor unit (not shown) may be arranged for collecting measurement data relating to operating conditions of the ESS 200, i.e. measuring temperature, voltage and current level of the associated battery pack 202. Measurement data from each sensor unit is transmitted to an associated battery management unit (BMU) 204, which is configured for managing the individual battery pack 202 during operation of the bus 201. The BMU 204 can also be configured for determining parameters indicating and controlling the condition or capacity of the battery pack 202, such as the state of charge (SOC), the state of health (SOH), the state of power (SOP) and the state of energy (SOE) of the battery pack 202.

The BMU 204 is connected to and configured to communicate with an ESS control unit 208, which controls the ESS 200. The ESS control unit 208 may include a microprocessor, a microcontroller, a programmable digital signal processor or another programmable device. Thus, the ESS control unit 208 comprises electronic circuits and connections (not shown) as well as processing circuitry (not shown) such that the ESS control unit 208 can communicate with different parts of the bus 201 or with different control units of the bus 201. The ESS control unit 208 may comprise modules in either hardware or software, or partially in hardware or software, and communicate using known transmission buses such as a CAN-bus and/or wireless communication capabilities. The processing circuitry may be a general purpose processor or a specific processor. The ESS control unit 208 comprises a non-transitory memory for storing computer program code and data. Thus, the skilled person realizes that the ESS control unit 208 may be embodied by many different constructions. This is also applicable to the BMU 204.

Turning now to Fig. 2, there is depicted a battery model comprising an equivalent circuit of the battery unit 202, also known as a Thevenin battery model. The exemplary equivalent circuit model comprises two RC circuits to model the battery unit, although a different number of RC circuits may be used in the model, such as one RC circuit or three RC circuits, depending on battery dynamics and application. The exemplary equivalent circuit model is used for estimation of the state of charge and capacity of the battery unit 202, and is typically implemented by the above mentioned control unit 208. The exemplified equivalent circuit model illustrated in Fig. 2 may be used for estimating the open circuit voltage $V_{OC}$ and capacity Q of the battery unit 202 based on direct battery measurements. The battery unit open circuit voltage estimation may for example be based on measured battery current inputs and a battery terminal voltage $V_b$.

The equivalent circuit model described in relation to Fig. 2 consists of an active electrolyte resistance and conductive resistance of electrodes (or internal ohmic resistance) $R_0$, connected in series with two RC branches. A first RC branch and a second RC branch comprise, respectively, capacitances $C_1$, $C_2$ and active charge transfer resistances $R_1$, $R_2$ connected in parallel. $V_b$ refers to terminal voltage output, $I_b$ refers to the current in the circuit and $V_{OC}$ refers to the battery open circuit voltage. For given values of the terms $V_{OC}$, $R_0$, $R_1$, $R_2$, $C_1$ and $C_2$, the terminal voltage $V_b$ can be expressed as a function of the current $I_b$. Normally $R_0$, $R_1$ and $R_2$ increase with age, while battery cell capacity (not illustrated in the figure) decreases with age. Voltages across the internal ohmic resistance $R_0$ and the first and second RC branches, respectively, are expressed as $V_0$, $V_1$ and $V_2$.

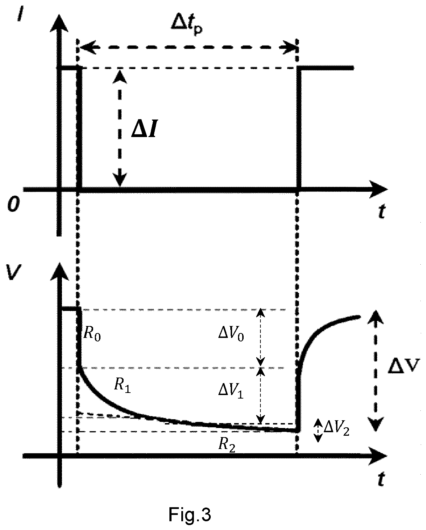

Fig. 3 shows current $I$ and voltage $V$ as functions of time $t$ during a time period $\Delta t_p$ after disconnection of a load from a battery unit modelled by the equivalent circuit model in fig. 2. While the load current $I$ changes abruptly by an amount $\Delta I$ upon disconnection of the load, the voltage drops gradually by a total amount $\Delta V$, corresponding to the terminal voltage $V_b$. The voltage first drops abruptly by an amount $\Delta V_0$, corresponding to the voltage across the internal resistance $R_0$. It thereafter drops gradually over the time period $\Delta t_p$.

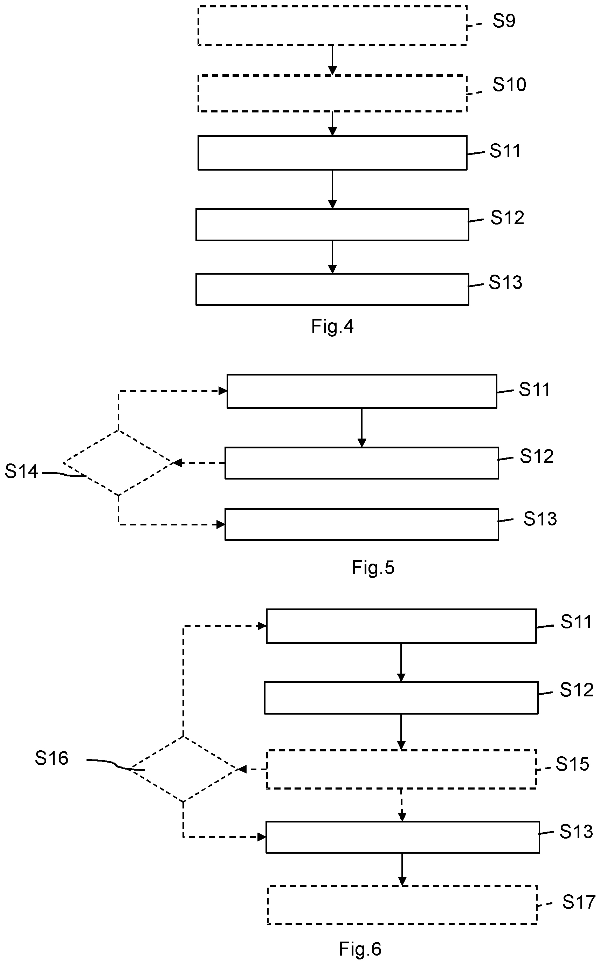

A method for estimating a capacity Q of a battery unit in an energy storage system, such as the battery unit 202 in the ESS 200 illustrated in fig. 1, is schematically illustrated in the flow-chart of fig. 4. The method comprises the following steps:

S11) During at least a first no-load condition of the battery unit 202, measuring the terminal voltage $V_b$ of the battery unit 202 at a number of points in time to determine a transient voltage response of the battery unit 202. This step is performed following disconnection of a load, such as an electric machine or an on-board charger. Thus, the step S11 may be performed either after a charge process or after a discharge process of the battery unit 202. The voltage drop upon disconnection of the load is gradual, in contrast to the sudden current drop, and the measured terminal voltage $V_b$ will follow a time curve whose appearance depends on the open circuit voltage $V_{OC}$ of the battery unit 202.

S12) From the transient voltage response of the battery unit 202 during at least the first no-load condition, estimating at least a first value of the open circuit voltage $V_{OC}$ of the battery unit 202 by means of a battery model. The battery model may e.g. be the second order equivalent circuit model described with reference to fig. 2, although other models may also be used for this purpose, such as an electrochemical model or a black box model. In order to estimate the open circuit voltage $V_{OC}$ using the second order equivalent circuit model, various batch estimation methods or recursive estimation methods may be used. Examples will be given below.

S13) Estimating the capacity Q of the battery unit 202 based on at least the estimated at least first value of the open circuit voltage $V_{OC}$.

The method may further comprise the optional steps, marked with dashed lines:
S9) During a second no-load condition of the battery unit 202, determining a second value of the open circuit voltage $V_{OC}$ of the battery unit, wherein a charge process or a discharge process occurs between the first no-load condition and the second no-load condition. In this case, the estimation of the capacity Q of the battery unit 202 is further based on the determined second value of the open circuit voltage $V_{OC}$ of the battery unit. The second value of the of the open circuit voltage $V_{OC}$ does not necessarily need to be determined in the same way as the first value, although it is of course possible to determine a value of the open circuit voltage $V_{OC}$ according to step S12 following each charge process or discharge process of the battery unit, which values may be used for estimation of the capacity in step S13. In the flow chart in fig. 4, the second no-load condition occurs before the first no-load condition.
S10) Measuring the battery current $I_b$ of the battery unit 202 during a charge process or a discharge process of the battery unit, wherein the charge process or discharge process precedes or succeeds the first no-load condition, during which the transient voltage response was/will be determined. The charge process or the discharge process may be the process immediately succeeding or preceding the first no-load condition. The charge process or discharge process may be the charge process or the discharge process occurring between the first no-load condition and the second no-load condition, such as illustrated in fig. 4. The estimation of the capacity of the battery unit, performed in step S13, is in this case further based on the measured battery current $I_b$ during said charge process or said discharge process. For example, the estimation of the capacity of the battery unit may in this case be estimated using Coulomb counting, taking the first and second values of the open circuit voltage $V_{OC}$ and the total current during the charge or discharge process into account. Under the assumption that the battery unit is charged or discharged in a state of charge (SOC) window $[z(t_0), z(t_f)]$ over a time interval $t \in [t_0, t_f]$, the battery capacity Q can be estimated as $\hat{Q}$ as follows, derived using Coulomb counting:

$$\hat{Q} = \frac{\int_{t_0}^{t_f} I_b(\tau) d\tau}{z(t_f) - z(t_0)}$$

where $z(t_0)$ and $z(t_f)$ are initial and final values of SOC during the charge or discharge process. The SOC is related to the open circuit voltage $V_{OC}$, and look-up tables may be used to find the SOC value corresponding to the determined first, and if applicable second, value(s) of the open circuit voltage $V_{OC}$ determined in steps S12 and S9, respectively.
As illustrated in the flow chart of fig. 5, the method may also comprise the optional step:
S14) Comparing the estimated at least first value of the open circuit voltage $V_{OC}$ to a predetermined convergence criterion, wherein the step S13 of the estimation of the capacity Q of the battery unit 202, based on the estimated at least first value of the open circuit voltage $V_{OC}$, is only carried out given that the predetermined convergence criterion is fulfilled. The convergence criterion may for example be set so that the obtained first value of the open circuit voltage is estimated repeatedly following disconnection of the load until two subsequently estimated first values of the open circuit voltage $V_{OC}$ differ from each other by less than a predetermined amount. If the predetermined convergence criterion is not fulfilled, steps S11 and S12 are resumed. Thus, step S14 is carried out after step S12 and is decisive of whether the method should proceed to step S13 or not.
As illustrated in the flow-chart of fig. 6, the method may also comprise the optional steps:

S15) Determining a level of uncertainty of the estimated at least first value of the open circuit voltage $V_{OC}$ as estimated in step S12. The open circuit voltage $V_{OC}$ is herein determined as a stochastic variable. The determined level of uncertainty may be used in step S16 and/or step S17 as explained below.

S16) Based on the determined level of uncertainty of the estimated at least first value of the open circuit voltage $V_{OC}$, determining if the estimated at least first value of the open circuit voltage $V_{OC}$ may be used for the estimation of the capacity Q of the battery unit. For example, if the estimated level is above a predetermined threshold, it may be determined that the value may not be used for capacity estimation in step S13. In this case, the method may be aborted and resumed at a later occasion, such as during a subsequent no-load condition of the battery unit 202. Alternatively, step S11 may be resumed to attempt to get a more accurate value of the open circuit voltage $V_{OC}$.

S17) Based on the determined level of uncertainty of the estimated at least first value of the open circuit voltage $V_{OC}$, determining a level of uncertainty of the estimated capacity Q of the battery unit 202. Thus, in this case, the capacity Q is also determined as a stochastic variable whose estimated uncertainty level is dependent on the uncertainty of the open circuit voltage $V_{OC}$. Step S17 may of course be carried out in close connection with step S13.

Although illustrated in three different flow charts, the steps S9-S17 may of course be combined in different ways. For example, the steps S9-S10 may be included also in the embodiments illustrated in figs. 5 and 6.

In step S12, the first value of the open circuit voltage $V_{OC}$ of the battery unit 202 may e.g. be estimated using the second order equivalent circuit model described with reference to fig. 2. The equivalent circuit model illustrated in fig. 2 can be described by the following equations:

$$V_1(k + 1) = a_1(k) \cdot V_1(k) + b_1(k) \cdot I_b(k),$$

$$V_2(k + 1) = a_2(k) \cdot V_2(k) + b_2(k) \cdot I_b(k),$$

$$SoC(k + 1) = SoC(k) + b_3(k) \cdot I_b(k),$$

$$V_b(k) = V_{oc}(k) + V_1(k) + V_2(k) + R_0(k) \cdot I_b(k),$$

where $V_{OC}$, $a_1$, $a_2$, $b_1$, $b_2$, and $b_3$ are constants.

Under a no load condition, when $I_b$=0, the model is reduced to

$$V_1(k) = a_1 \cdot V_1(k - 1),$$

$$V_2(k) = a_2 \cdot V_2(k - 1),$$

$$V_b(k) = V_{oc} + V_1(k) + V_2(k),$$

where $V_{OC}$, $a_1$ and $a_2$ are constants.

Depending on the type of battery unit, two different cases apply, which may be treated separately.

Example case 1

In a first case, a fast decay of activation polarization of the battery unit 202 is assumed, corresponding to a fast voltage drop $\Delta V_1$ across the first RC branch of the equivalent circuit model as the load is removed. In this case, the voltage $V_1$ across the first RC branch may be neglected and the model is further simplified to

$$V_2(k) = a_2 \cdot V_2(k - 1),$$

$$V_b(k) = V_{oc} + V_2(k),$$

which can be rewritten on a one step ahead predictor form as

$$V_b(k) = V_{oc} + a_2 \cdot (V_b(k-1) - V_{oc}),$$

$$y(k) = \varphi(k) \cdot \theta,$$

where

$$y = V_b,$$

$$\varphi = [\varphi_1 \quad \varphi_2] = [y(k-1) \quad 1],$$

$$\theta = \begin{bmatrix} \theta_1 \\ \theta_2 \end{bmatrix} = \begin{bmatrix} a_2 \\ (1-a_2)V_{oc} \end{bmatrix}.$$

Based on the above model, the parameter vector $\theta$ is estimated, for example using a batch estimation method or a recursive estimation method, such as a recursive least squares method. The open circuit voltage $V_{OC}$ is thereafter estimated as:

$$V_{oc} = \frac{\theta_2}{1 - \theta_1}.$$

Example case 2

In a second and more general case, a fast decay of activation polarization of the battery unit 202 cannot be assumed. In this case, the voltage drops more slowly across the first RC branch of the equivalent circuit model as the load is removed. Thus, the voltage $V_1$ across the first RC branch may not be neglected. This case can be handled by re-parameterizing the output equation on a 2nd order autoregressive form that leads to a 2nd order output predictor equation:

$$y = (a_1 + a_2) \cdot y(k-1) - a_1 a_2 \cdot y(k-2) - (a_1 + a_2 - a_1 a_2) \cdot V_{oc},$$

$$y = \varphi \cdot \theta.$$

where

$$\varphi = [\varphi_1 \quad \varphi_2 \quad \varphi_3] = [y(k-1) \quad y(k-2) \quad 1],$$

$$\theta = \begin{bmatrix} \theta_1 \\ \theta_2 \\ \theta_3 \end{bmatrix} = \begin{bmatrix} a_1 + a_2 \\ a_1 a_2 \\ (1 - \theta_1 + \theta_2)V_{oc} \end{bmatrix}.$$

The equation may be solved for the parameter vector $\theta$ using recursive or batch optimization approaches. The open circuit voltage $V_{OC}$ may thereafter be estimated as follows:

$$V_{oc} = \frac{\theta_3}{1 - \theta_1 + \theta_2}$$

One particular approach to find the parameter vector $\theta$ and the open circuit voltage $V_{OC}$ based on a recursive least-squares is given below:

$$K_k = \frac{P_{k-1}\varphi_k}{\lambda + \varphi_k^T P_{k-1}\varphi_k},$$

$$P_k = \frac{(1 - K_k\varphi_k^T)P_{k-1}}{\lambda},$$

$$e(k) = V_b(k) - \varphi_k^T \hat{\theta}(k-1),$$

$$\hat{\theta}(k) = \hat{\theta}(k-1) + K_k e(k),$$

where A and the initialization of P are tuning parameters, representing a forgetting factor and a covariance matrix, respectively, and wherein k represents a time sample. When the parameters have converged, the open circuit voltage may be estimated as defined above.

It is to be noted that the same solution may be found using various recursive and batch estimation and filtering techniques. For example, a batch least squares (RLS) technique can be used, which however requires more memory.

A convergence criterion that may be used is

$$y(k) = \sum_{k=k_0}^{k_0-m} |e(k)| < \varepsilon,$$

where $e(k)$ is defined above, $k_0$ is the current time step, and $m$ and $\varepsilon$ are tuning parameters.

Although the figures may show a sequence, the order of the steps may differ from what is depicted. Also two or more steps may be performed concurrently or with partial concurrence. Such variation will depend on the software and hardware systems chosen and on designer choice. All such variations are within the scope of the disclosure. Likewise, software implementations could be accomplished with standard programming techniques with rule based logic and other logic to accomplish the various connection steps, processing steps, comparison steps and decision steps. Additionally, even though the invention has been described with reference to specific exemplifying embodiments thereof, many different alterations, modifications and the like will become apparent for those skilled in the art.

The estimated capacity of the battery unit may e.g. be communicated to an electronic control unit of the vehicle, such as an engine control unit (ECU). The estimated operating parameter may be communicated at time intervals depending on e.g. operating conditions of the ESS 200, or in real time.

The control functionality of the example embodiments may be implemented using existing computer processors, or by a special purpose computer processor for an appropriate system, incorporated for this or another purpose, or by a hardwire system. Embodiments within the scope of the present disclosure include program products comprising machine-readable medium for carrying or having machine-executable instructions or data structures stored thereon. Such machine-readable media can be any available media that can be accessed by a general purpose or special purpose computer or other machine with a processor. By way of example, such machine-readable media can comprise RAM, ROM, EPROM, EEPROM, CD-ROM or other optical disk storage, magnetic disk storage or other magnetic storage devices, or any other medium which can be used to carry or store desired program code in the form of machine-executable instructions or data structures and which can be accessed by a general purpose or special purpose computer or other machine with a processor. When information is transferred or provided over a network or another communications connection (either hardwired, wireless, or a combination of hardwired or wireless) to a machine, the machine properly views the connection as a machine-readable medium. Thus, any such connection is properly termed a machine-readable medium. Combinations of the above are also included within the scope of machine-readable media. Machine-executable instructions include, for example, instructions and data which cause a general purpose computer, special purpose computer, or special purpose processing machines to perform a certain function or group of functions.

It is to be understood that the present invention is not limited to the embodiments described above and illustrated in the drawings; rather, the skilled person will recognize that many changes and modifications may be made within the scope of the appended claims. For example, although the present invention has mainly been described in relation to an electrical bus, the invention should be understood to be equally applicable for any type of electric vehicle, in particular an electric truck or the like.

**Claims**

1.   A method for estimating a capacity (Q) of a battery unit (202) in an energy storage system (200) of a vehicle (201), the method comprising:

   - during at least a first no-load condition of the battery unit, measuring (S11) a terminal voltage ($V_b$) of the battery unit (202) at a number of points in time to determine a transient voltage response of the battery unit (202),
   - from the transient voltage response of the battery unit (202) during at least the first no-load condition, estimating (S12) at least a first value of an open circuit voltage ($V_{OC}$) of the battery unit (202) by means of a battery model,

   **characterised in that** the method further comprises:

   - comparing (S14) the estimated at least first value of the open circuit voltage (Voc) to at least one predetermined convergence criterion,
   - estimating (S13) the capacity (Q) of the battery unit (202) based on at least the estimated at least first value of the open circuit voltage ($V_{OC}$), wherein the estimation of the capacity (Q) of the battery unit (202) is only carried out given that the at least one predetermined convergence criterion is fulfilled.

2.   The method according to claim 1, further comprising:

   - measuring (S10) a battery current ($I_b$) of the battery unit (202) during a charge process or a discharge process of the battery unit (202), wherein said charge process or discharge process precedes or succeeds said first no-load condition,

   wherein the estimation of the capacity (Q) of the battery unit (202) is further based on the measured battery current ($I_b$) during said charge process or said discharge process.

3.   The method according to claim 2, further comprising:

   - during a second no-load condition of the battery unit (202), determining (S9) a second value of the open circuit voltage ($V_{OC}$) of the battery unit (202), wherein said charge process or discharge process occurs between the first no-load condition and the second no-load condition,

   wherein the estimation of the capacity (Q) of the battery unit (202) is further based on the determined second value of the open circuit voltage ($V_{OC}$) of the battery unit (202).

4.   The method according to any one of the preceding claims, wherein the terminal voltage ($V_b$) used to determine the transient voltage response is measured within a predetermined period of time after a termination of an immediately preceding charge process or discharge process of the battery unit (202).

5.   The method according to any one of the preceding claims, wherein the estimation of the capacity (Q) of the battery unit (202) based on at least the estimated at least first value of the open circuit voltage ($V_{OC}$) comprises using Coulomb counting.

6.   The method according to any one of the preceding claims, further comprising:

   - determining (S15) a level of uncertainty of the estimated at least first value of the open circuit voltage ($V_{OC}$).

7.   The method according to claim 6, further comprising:

- based on said determined level of uncertainty of the estimated at least first value of the open circuit voltage ($V_{OC}$), determining (S16) if the estimated at least first value of the open circuit voltage ($V_{OC}$) may be used for said estimation of the capacity (Q) of the battery unit.

8. The method according to claim 6 or 7, further comprising:

- based on said determined level of uncertainty of the estimated at least first value of the open circuit voltage ($V_{OC}$), determining (S17) a level of uncertainty of the estimated capacity (Q) of the battery unit (202).

9. The method according to any one of the preceding claims, wherein the battery model used in the estimation of the at least first value of the open circuit voltage ($V_{OC}$) is an equivalent circuit model, preferably a second order equivalent circuit model comprising at least two resistor-capacitor branches.

10. The method according to any one of the preceding claims, wherein a recursive estimation method or a batch estimation method is used in the estimation of the at least first value of the open circuit voltage ($V_{OC}$), or wherein a recursive least squares estimation method is used in the estimation of the at least first value of the open circuit voltage ($V_{OC}$).

11. A computer program comprising program code means for performing the method according to any one of the preceding claims when said computer program is run on a control unit according to claim 13.

12. A computer-readable medium carrying a computer program according to claim 11.

13. A control unit (208) configured to perform the method according to any one of claims 1-10.

14. A battery management system for an energy storage system (200) comprising the control unit (208) according to claim 13.

15. A vehicle (201), such as a hybrid vehicle or a fully electrified vehicle, comprising an energy storage system (200) and a control unit (208) according to claim 13.


**Patentansprüche**

1. Verfahren zum Schätzen einer Kapazität (Q) einer Batterieeinheit (202) in einem Energiespeichersystem (200) eines Fahrzeugs (201), das Verfahren umfassend:

- während mindestens einer ersten Leerlastbedingung der Batterieeinheit, Messen (S11) einer Klemmenspannung ($V_b$) der Batterieeinheit (202) an einer Anzahl von Zeitpunkten, um eine Übergangsspannungsantwort der Batterieeinheit (202) zu bestimmen,
- von der Übergangsspannungsantwort der Batterieeinheit (202) während mindestens der ersten Leerlastbedingung, Schätzen (S12) mindestens eines ersten Werts einer Leerlaufspannung ($V_{OC}$) der Batterieeinheit (202) mittels eines Batteriemodells, **dadurch gekennzeichnet, dass** das Verfahren ferner umfasst:

- Vergleichen (S14) des geschätzten mindestens ersten Werts der Leerlaufspannung ($V_{OC}$) mit mindestens einem vorbestimmten Konvergenzkriterium,
- Schätzen (S13) der Kapazität (Q) der Batterieeinheit (202) basierend auf mindestens dem geschätzten mindestens ersten Wert der Leerlaufspannung ($V_{OC}$), wobei die Schätzung der Kapazität (Q) der Batterieeinheit (202) nur dann durchgeführt wird, wenn das mindestens eine vorbestimmte Konvergenzkriterium erfüllt ist.

2. Verfahren nach Anspruch 1, ferner umfassend:

- Messen (S10) eines Batteriestroms ($I_b$) der Batterieeinheit (202) während eines Ladevorgangs oder eines Entladevorgangs der Batterieeinheit (202), wobei der Ladevorgang oder der Entladevorgang dem ersten Leerlastzustand vorausgeht oder diesem folgt,

wobei die Schätzung der Kapazität (Q) der Batterieeinheit (202) ferner auf dem gemessenen Batteriestrom ($I_b$)

während des Ladevorgangs oder des Entladevorgangs basiert.

3. Verfahren nach Anspruch 2, ferner umfassend:

    - während eines zweiten Leerlastzustands der Batterieeinheit (202), Bestimmen (S9) eines zweiten Werts der Leerlaufspannung ($V_{OC}$) der Batterieeinheit (202), wobei der Ladevorgang oder der Entladevorgang zwischen dem ersten Leerlastzustand und dem zweiten Leerlastzustand erfolgt,

    wobei die Schätzung der Kapazität ($Q$) der Batterieeinheit (202) ferner auf dem bestimmten zweiten Wert der Leerlaufspannung ($V_{OC}$) der Batterieeinheit (202) basiert.

4. Verfahren nach einem der vorstehenden Ansprüche, wobei die Klemmenspannung ($V_b$), die verwendet wird, um die Übergangsspannungsantwort zu bestimmen, innerhalb eines vorbestimmten Zeitraums nach einer Beendigung eines unmittelbar vorangehenden Ladevorgangs oder Entladevorgangs der Batterieeinheit (202) gemessen wird.

5. Verfahren nach einem der vorstehenden Ansprüche, wobei die Schätzung der Kapazität ($Q$) der Batterieeinheit (202) basierend auf mindestens dem geschätzten mindestens ersten Wert der Leerlaufspannung (Voc) das Verwenden der Coulomb-Zählung umfasst.

6. Verfahren nach einem der vorstehenden Ansprüche, ferner umfassend:

    - Bestimmen (S15) eines Unsicherheitsniveaus des geschätzten mindestens ersten Werts der Leerlaufspannung ($V_{OC}$).

7. Verfahren nach Anspruch 6, ferner umfassend:

    - basierend auf dem bestimmten Unsicherheitsniveau des geschätzten mindestens ersten Werts der Leerlaufspannung ($V_{OC}$), Bestimmen (S16), ob der geschätzte mindestens erste Wert der Leerlaufspannung ($V_{OC}$) für die Schätzung der Kapazität (Q) der Batterieeinheit verwendet werden kann.

8. Verfahren nach Anspruch 6 oder 7, ferner umfassend:

    - basierend auf dem bestimmten Unsicherheitsniveau des geschätzten mindestens ersten Werts der Leerlaufspannung ($V_{OC}$), Bestimmen (S17) eines Unsicherheitsniveaus der geschätzten Kapazität ($Q$) der Batterieeinheit (202).

9. Verfahren nach einem der vorstehenden Ansprüche, wobei das bei der Schätzung des mindestens ersten Werts der Leerlaufspannung ($V_{OC}$) verwendete Batteriemodell ein Ersatzschaltungsmodell, vorzugsweise ein Ersatzschaltungsmodell zweiter Ordnung, umfassend mindestens zwei Widerstandskondensatorzweige, ist.

10. Verfahren nach einem der vorstehenden Ansprüche, wobei ein Verfahren rekursiver Schätzung oder ein Batch-Schätzungsverfahren bei der Schätzung des mindestens ersten Werts der Leerlaufspannung ($V_{OC}$) verwendet wird oder wobei ein Verfahren zur rekursiven Schätzung der kleinsten Quadrate bei der Schätzung des mindestens ersten Werts der Leerlaufspannung ($V_{OC}$) verwendet wird.

11. Computerprogramm, umfassend Programmcodemittel zum Durchführen des Verfahrens nach einem der vorstehenden Ansprüche, wenn das Computerprogramm auf einer Steuereinheit nach Anspruch 13 ausgeführt wird.

12. Computerlesbares Medium, das ein Computerprogramm nach Anspruch 11 trägt.

13. Steuereinheit (208), die konfiguriert ist, um das Verfahren nach einem der Ansprüche 1 bis 10 durchzuführen.

14. Batteriemanagementsystem für ein Energiespeichersystem (200), umfassend die Steuereinheit (208) nach Anspruch 13.

15. Fahrzeug (201), wie etwa ein Hybridfahrzeug oder ein vollständig elektrifiziertes Fahrzeug, umfassend ein Energiespeichersystem (200) und eine Steuereinheit (208) nach Anspruch 13.

**Revendications**

1. Procédé d'estimation de la capacité (Q) d'une pile de batterie (202) dans un système de stockage d'énergie (200) d'un véhicule (201), le procédé comprenant :

   - pendant au moins un premier état de non-charge de la pile de batterie, la mesure (S11) d'une tension de borne ($V_b$) de la pile de batterie (202) à un certain nombre d'instants afin de déterminer une réponse de tension transitoire de la pile de batterie (202),
   - à partir de la réponse de tension transitoire de la pile de batterie (202) pendant au moins le premier état de non-charge, l'estimation (S12) d'au moins une première valeur d'une tension de circuit ouvert ($V_{OC}$) de la pile de batterie (202) au moyen d'un modèle de batterie, **caractérisé en ce que** le procédé comprend en outre :

   - la comparaison (S14) de l'au moins une première valeur estimée de la tension de circuit ouvert ($V_{OC}$) à au moins un critère de convergence prédéfini,
   - l'estimation (S13) de la capacité (Q) de la pile de batterie (202) en fonction au moins de l'au moins une première valeur estimée de la tension de circuit ouvert ($V_{OC}$), dans lequel l'estimation de la capacité (Q) de la pile de batterie (202) est uniquement réalisée étant donné que l'au moins un critère de convergence prédéfini est rempli.

2. Procédé selon la revendication 1, comprenant en outre :

   - la mesure (S10) d'un courant de batterie ($I_b$) de la pile de batterie (202) pendant un processus de charge ou un processus de décharge de la pile de batterie (202), dans lequel ledit processus de charge ou processus de décharge précède ou suit ledit premier état de non-charge,

   dans lequel l'estimation de la capacité (Q) de la pile de batterie (202) est en outre basée sur le courant de batterie ($I_b$) mesuré pendant ledit processus de charge ou ledit processus de décharge.

3. Procédé selon la revendication 2, comprenant en outre :

   - pendant un second état de non-charge de la pile de batterie (202), la détermination (S9) d'une seconde valeur de la tension de circuit ouvert ($V_{OC}$) de la pile de batterie (202), dans lequel ledit processus de charge ou processus de décharge se produit entre le premier état de non-charge et le second état de non-charge,

   dans lequel l'estimation de la capacité (Q) de la pile de batterie (202) est en outre basée sur la seconde valeur déterminée de la tension de circuit ouvert ($V_{OC}$) de la pile de batterie (202).

4. Procédé selon l'une quelconque des revendications précédentes, dans lequel la tension terminale ($V_b$) utilisée pour déterminer la réponse de tension transitoire est mesurée dans une période de temps prédéfinie à la fin d'un processus de charge immédiatement précédent ou d'un processus de décharge de la pile de batterie (202).

5. Procédé selon l'une quelconque des revendications précédentes, dans lequel l'estimation de la capacité (Q) de la pile de batterie (202) en fonction d'au moins la première valeur estimée de la tension de circuit ouvert ($V_{OC}$) comprend l'utilisation du comptage de Coulomb.

6. Procédé selon l'une quelconque des revendications précédentes, comprenant en outre :

   - la détermination (S15) d'un niveau d'incertitude de l'au moins une première valeur estimée de la tension de circuit ouvert ($V_{OC}$).

7. Procédé selon la revendication 6, comprenant en outre :

   - en fonction dudit niveau d'incertitude déterminé de l'au moins première valeur estimée de la tension de circuit ouvert ($V_{OC}$), la détermination (S16) du fait de savoir si l'au moins une première valeur estimée de la tension de circuit ouvert ($V_{OC}$) peut être utilisée pour ladite estimation de la capacité (Q) de la pile de batterie.

8. Procédé selon la revendication 6 ou 7, comprenant en outre :

- en fonction dudit niveau d'incertitude déterminé de l'au moins une première valeur estimée de la tension de circuit ouvert ($V_{OC}$), la détermination (S17) d'un niveau d'incertitude de la capacité ($Q$) estimée de la pile de batterie (202).

9. Procédé selon l'une quelconque des revendications précédentes, dans lequel le modèle de batterie utilisé dans l'estimation de l'au moins une première valeur de la tension de circuit ouvert ($V_{OC}$) est un modèle de circuit équivalent, de préférence un modèle de circuit équivalent de second ordre comprenant au moins deux branches résistance-condensateur.

10. Procédé selon l'une quelconque des revendications précédentes, dans lequel un procédé d'estimation récursif ou un procédé d'estimation de lot est utilisé dans l'estimation de l'au moins une première valeur de la tension de circuit ouvert ($V_{OC}$), ou dans lequel un procédé d'estimation récursif des moindres carrés est utilisé dans l'estimation de l'au moins une première valeur de la tension de circuit ouvert ($V_{OC}$).

11. Programme informatique comprenant un moyen de code de programme permettant de mettre en oeuvre le procédé selon l'une quelconque des revendications précédentes lorsque ledit programme informatique est exécuté sur une unité de commande selon la revendication 13.

12. Support lisible par ordinateur comportant un programme informatique selon la revendication 11.

13. Unité de commande (208) configurée pour mettre en oeuvre le procédé selon l'une quelconque des revendications 1 à 10.

14. Système de gestion de batterie destiné à un système de stockage d'énergie (200) comprenant l'unité de commande (208) selon la revendication 13.

15. Véhicule (201), tel qu'un véhicule hybride ou un véhicule entièrement électrifié, comprenant un système de stockage d'énergie (200) et une unité de commande (208) selon la revendication 13.

Fig. 1

Fig. 2

Fig.3

S9

S10

S11

S12

S13

Fig.4

S14

S11

S12

S13

Fig.5

S16

S11

S12

S15

S13

S17

Fig.6

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6163133 A
- US 2014350877 A1
- US 2008255783 A1
- US 2009322283 A1
- US 2017363690 A1

**Non-patent literature cited in the description**

- **FARMANN, A. et al.** Critical review of on-board capacity estimation techniques for lithium-ion batteries in electric and hybrid electric vehicles. *Journal of Power Sources,* 2015, vol. 281, 114-130